(19) Europäisches Patentamt / European Patent Office / Office européen des brevets

(11) **EP 3 239 349 B1**

(12) **EUROPEAN PATENT SPECIFICATION**

(45) Date of publication and mention of the grant of the patent:
**22.06.2022 Bulletin 2022/25**

(21) Application number: **16167040.1**

(22) Date of filing: **26.04.2016**

(51) International Patent Classification (IPC):
**C23C 14/06** (2006.01)   **C23C 14/32** (2006.01)
**C23C 14/54** (2006.01)   **C23C 28/04** (2006.01)

(52) Cooperative Patent Classification (CPC):
**C23C 14/0605; C23C 14/325; C23C 14/541; C23C 28/046; C23C 28/42**

(54) **WEAR RESISTANT TETRAHEDRAL DIAMOND LIKE CARBON LAYER**

VERSCHLEISSFESTE TETRAEDERFÖRMIGE DIAMANTÄHNLICHE KOHLENSTOFFSCHICHT

COUCHE DE CARBONE RÉSISTANT À L'USURE SEMBLABLE À UN DIAMANT TÉTRAHÉDRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**01.11.2017 Bulletin 2017/44**

(73) Proprietor: **IHI Ionbond AG**
**4657 Dulliken (CH)**

(72) Inventors:
• **Van der Kolk, Gerrit-Jan**
**5928 LL Venlo (NL)**
• **Dolchinkov, Ivailo**
**4657 Dulliken (CH)**

(74) Representative: **Hoffmann Eitle**
**Patent- und Rechtsanwälte PartmbB**
**Arabellastraße 30**
**81925 München (DE)**

(56) References cited:
**JP-A- 2005 350 763**

• **PATSALAS P ET AL: "Surface and interface morphology and structure of amorphous carbon thin and multilayer films", DIAMOND AND RELATED MATERIALS, ELSEVIER SCIENCE PUBLISHERS, AMSTERDAM, NL, vol. 14, no. 8, 25 February 2005 (2005-02-25), pages 1241-1254, XP027813386, ISSN: 0925-9635 [retrieved on 2005-08-01]**

• **MATHIOUDAKIS C ET AL: "Nanomechanical properties of multilayered amorphous carbon structures", PHYSICAL REVIEW. B, CONDENSED MATTER AND MATERIALS PHYSICS, AMERICAN PHYSICAL SOCIETY, US, vol. 65, no. 20, 15 May 2002 (2002-05-15), pages 205203/1-14, XP002458383, ISSN: 1098-0121, DOI: 10.1103/PHYSREVB.65.205203**

• **FENGJI LI ET AL: "Multilayer DLC coatings via alternating bias during magnetron sputtering", THIN SOLID FILMS, vol. 519, no. 15, 13 January 2011 (2011-01-13), pages 4910-4916, XP028384977, ISSN: 0040-6090, DOI: 10.1016/J.TSF.2011.01.052 [retrieved on 2011-01-13]**

• **ZHANG YUJUAN ET AL: "Effect of microstructure and mechanical properties difference between sub-layers on the performance of alternate hard and soft diamond-like carbon multilayer films", SURFACE AND COATINGS TECHNOLOGY, vol. 232, 14 June 2013 (2013-06-14), pages 575-581, XP028707128, ISSN: 0257-8972, DOI: 10.1016/J.SURFCOAT.2013.06.030**

• **ZAVALEYEV V ET AL: "Effect of substrate temperature on properties of diamond-like films deposited by combined DC impulse vacuum-arc method", SURFACE AND COATINGS TECHNOLOGY, vol. 236, 26 October 2013 (2013-10-26), pages 444-449, XP028788630, ISSN: 0257-8972, DOI: 10.1016/J.SURFCOAT.2013.10.023**

# Description

## Technical Field

The present invention as defined in the appended claims, relates to a wear resistant tetrahedral diamond like carbon (DLC) layer or film.

## State of the Art

Coatings made of diamond like carbon have been used for quite some time as coatings for objects such as drill bits or piston rings in order to reduce friction and wear resistance. Typically, hydrogenated DLC has been used, which has a hardness in the range of from 2500-4000 Hv and which has an application temperature of up to 300°C, which limits its usability. Non-hydrogenated DLC has also been used and typically has a higher hardness and a higher operational temperature of up to 600°C. Non-hydrogenated DLC is also more easily wetted by a number of lubricants than hydrogenated DLC.

A key property of non-hydrogenated DLC is its hardness, which is directly related to the ratio between $sp^3$ and $sp^2$-bonds between adjacent carbon atoms. Generally speaking, a higher $sp^3$-fraction results in a higher hardness.

There are several prior art documents discussing coatings. J. Patscheider et al., "Structure-performance relations in nanocomposite coatings", Surface and Coatings Technology 146-147 (2001) 201-208, gives an overview over the field. Generally speaking, PVD and CVD-methods and its derivatives have been used to enhance the performance of base materials which are coated, in particular their wear resistance or so as to reduce their coefficient of friction. Those methods can also be used for producing multilayer coatings.

When producing such multilayer coatings, it is often the case that the individual layers have different compositions. This can be obtained by performing coating using PVD and/or CVD with different vapors. An alternative way forward of a producing a multilayer coating, which in this case would have a chemically constant composition, would be to merely change the deposition conditions when performing a PVD or a CVD method. In such a case, the composition does not vary, but there is a (small) variation in either the stoichiometry and/or the crystal structure. Examples of such multilayer structures are disclosed, for the case of ceramics, in EP 2 298 954 A1, where the grain size of a coating is modulated by changing some of the deposition parameters, and in EP 2 561 118 B1 where the bias voltage is modulated during deposition of the coating, which is reported to enhance the cutting performance of the tools which are coated. Both of these documents relate to modulations within a homogenous composition of a ceramic nitride or carbide based coating.

Those two prior art documents rely on a change of the deposition parameters. A rotation of the products in front of an evaporation cathode takes place, and since it is essential that all of the coated products have similar coatings, the step times are taken so long that all products have a similar modulation of their structure. In EP 2 298 954 A1, one achieves a minimum modulation on the order of magnitude of about 100 nm. US 6,066,399 discusses another way of producing carbon based coatings.

Several other documents discuss ways of producing modulations on the nm-scale, such as P.Eh. Hovsepian et al., "Recent progress in large scale manufacturing of multilayer/superlattice hard coatings", Surface and Coatings

Technology 133-134 (2000) 166-175, where the modulations in the nm-scale are caused by modulating the composition due to rotating the samples to be coated in front of cathodes with different cathode materials. J. Musil, "Hard nanocomposite coatings: Thermal stability, oxidation resistance and toughness", Surface & Coatings Technology 207 (2012) 50-65, discusses coatings modulated on a nanoscale due to nano-crystallisation of the amorphous phase by fluctuation of the power delivered to the growing coating during rotation in front of the cathodes. Another example of producing a modulation on a nanoscale is given in C. Strondl et al., "Properties and characterization of multilayers of carbides and diamond-like carbon", Surface and Coatings Technology 142-144 (2001) 707-713, whereby a rotation of the sample in front of tungsten cathodes during deposition of the DLC layer from the gas phase results in the modulation of WC rich and WC poor layers. In the deposition of tetrahedral carbon DLC layers, pulsed laser vacuum arc deposition has been used (cf. B. Schultrich et al., "Deposition of superhard amorphous carbon films by pulsed vacuum arc deposition", Surface and Coatings Technology 98 (1998) 1097-1101, and T. Witke et al., "Comparison of filtered high-current pulsed arc deposition (Φ-HCA) with conventional vacuum arc methods", Surface and Coatings Technology 126 (2000) 81-88.

P. Patsalas et al., "Surface and interface morphology and structure of amorphous carbon thin and multilayer films", Diamonds & Related Materials 14 (2005) 1241-1254 discloses feature falling under the preamble of claim 1, C. Mathioudakis et al. "Nanomechanical properties of multilayered amorphous carbon structures", Phys. Rev. B (65) 205203, JP 2005-350 763 A, and Fengji Li et al., "Multilayer DLC coatings via alternating bias during magnetron sputtering", Thin Solid Films 519 (2011) 4910-4916, are further prior art.

## Summary of the Invention

The present inventors have realized that hard coatings according to the prior art are insufficient in terms of wear properties. This applies in particular to DLC coatings, especially to non-hydrogenated tetrahedral DLC coatings. By having a high $sp^3$-fraction, one obtains a higher hardness of the DLC layer. However, a high hardness typically correlates with a high internal compressive stress and a high Young's modulus, resulting in wear through locally chipping out of the coating. On the other hand, having a high $sp^2$-fraction avoids such problems but also leads to a lower hardness of the DLC layer thus produced.

Thus, the present invention is aimed at improving the DLC-films, in particular non-hydrogenated tetrahedral DLC films according to the prior art. The invention further aims at providing methods and apparatuses specifically designed for producing such films.

The invention is defined by the appended independent claim. Preferred embodiments are defined in the dependent claims.

Claim 1 relates to a substrate coated with a carbon film. Typical substrates to be coated are drill bits or piston rings used in internal combustion engines. The purpose of having such a coating is to reduce wear and tear of such a surface.

It is preferred that the carbon film is a tetrahedral diamond-like carbon (DLC) film. A diamond-like carbon film is a film made of an amorphous carbon material. DLC has been used as a coating material since it is, in some respects, similar in its properties to diamond. More in terms of the properties of the bonds between neighboring carbon atoms, in diamond-like carbon atoms, there is a considerable fraction of carbon atoms which are bonded to each other using $sp^3$-bonds. However, not all of the atoms are bonded each other using such bonds, which distinguishes a diamond-like carbon (DLC) coating from a pure diamond. Diamond-like carbon films can be produced using physical vapor deposition (PVD). It is preferred to use tetrahedral diamond-like carbon films, since such a film is known for its superior hardness and good wear properties. In such a diamond-like carbon film, the structure of the atomic bonds of at least parts of the carbon layer is in the form of a tetrahedron. Such a film significantly increases the lifetime of a substrate coated with it.

According to claim 1, the carbon film has an oscillating variation of the $sp^2/sp^3$-ratio in the thickness direction of the carbon film so that neighboring regions having a high $sp^2/sp^3$-ratio are spaced apart from each other by at least 0.2 nm and sandwich a region having a lower $sp^2/sp^3$-ratio. That is, the carbon thin film according to the present invention has an oscillating variation in the fraction of the carbon-carbon bonds which are $sp^2$-bonds and which are $sp^3$-bonds so as to produce regions having a comparatively high fraction of $sp^2$-bonds (in the following called "$sp^2$-rich regions") and regions having a comparatively lower fraction of $sp^2$-bonds (in the following called "$sp^3$-rich regions"), corresponding to a high and lower fraction of $sp^3$-bonds, respectively.

Those regions typically extend across at least a substantial part of the area of the film, that is, those regions are oriented in essence parallel to the surface they are coating and extend parallel to that surface for a significant part of that surface. Those regions typically form distinct layers which can be distinguished from each other by their high/low(er) $sp^2/sp^3$-ratio. Such layers can be produced using the method discussed further below.

The $sp^2/sp^3$-ratio can be measured using electron energy loss spectroscopy (EELS).

The $sp^2$-fraction can for instance be obtained by measuring the integrated intensity ratio of C-K edge

$$1s \rightarrow \Pi^\divideontimes$$

peak (

$$I_{\Pi\divideontimes}$$

) at 285.5 eV of the deposited carbon, preferably tetrahedral non-hydrogenated carbon (ta-C) film, and a reference (graphite). Thereby, a suitable beam width of for instance 5 nm can be used. This yields the $sp^2$ fraction in the coating. Such EELS method that can be used to derive the $sp^2$ fraction is described by S.D. Berger et al., Phil. Mag. Lett. 57 (1988) 285.

Another method to determine the $sp^2/sp^3$ ratio by means of EELs is described in the paper by A. J. Papworth et al., "Electron-energy-loss spectroscopy characterization of the sp2 bonding fraction within carbon thin films", Phys. Rev. B, 62(2000) 12628-12631. The method described in the paper is based on an analysis of the EELS spectrum which shows peaks at 285 eV and 293 eV which are indicative of the $sp^2$ and $sp^3$-fraction, respectively, using $C_{60}$ as a standard.

Raman spectroscopy can also be used to investigate the $sp^2/sp^3$ ratio. Raman spectroscopy relies on the inelastic scattering of photons, which is more pronounced at $sp^2$ bonds.

According to claim 1, neighboring regions having a high $sp^2/sp^3$-ratio are spaced apart from each other by at least 0.2 nm. They can also be spaced apart from each other by at least 10 nm. A minimum spacing of 5 nm is particularly preferred. This spacing between two neighboring regions (that is, directly neighboring regions) which have a high $sp^2/sp^3$-ratio is defined as the distance between the respective centers of regions having a high $sp^2/sp^3$-ratio. This feature is advantageous in that a variation of the bonds of the carbon films at a sub-nanoscale is present whilst also being sufficiently long range to ensure that variations in the $sp^2/sp^3$-ratio due to noise are excluded. The feature that those two neighboring regions sandwich a region having a lower $sp^2/sp^3$-ratio covers the concept that regions having a high $sp^2/sp^3$-ratio and regions having a lower $sp^2/sp^3$-ratio are "stacked" upon each other in an alternating fashion.

It is preferred that the distance between neighboring regions having a high $sp^2/sp^3$-ratio is less than 50 nm, preferably less than 25 nm, more preferably less than 15 nm, even more preferably less than 10 nm. Those length scales serve to ensure that the variations are at the nanoscale so as to have a significantly low-range variation.

By having a carbon film where the $sp^2/sp^3$-ratio varies on a nanoscale in the manner described above, the problems with the uniform DLC layers discussed above are avoided. Thanks to the $sp^3$-rich layers, the film exhibits a high hardness, and thanks to the $sp^2$-rich layers, the local chipping out of the film is avoided. In particular, one has a lower inherent compressive stress thanks to the $sp^2$-rich layers, which means that if chipping out is to occur, it occurs at the level of the horizontal planes formed by the individual layers, rather than through the whole film. In consequence, the film thus produced has a long lifetime whilst also having advantageous mechanical properties.

It is preferred that the carbon film has a hydrogen content of less than 1 mole percent (mol-%). Having such a carbon film is advantageous in that the carbon film has better mechanical properties, in particular a reduced wear and tear. Such a carbon film can also be referred to as a non-hydrogenated carbon film. According to a preferred embodiment, the carbon film of the invention is a non-hydrogenated tetrahedral diamond like carbon (DLC) film, sometimes abbreviated as "ta-C" film.

It is according to the invention, to have a fraction of the bonds between carbon atoms which are $sp^2$-bonds in those regions which have a high $sp^2/sp^3$-ratio within the range of from 40% to 50%, preferably within the range of from 41% to 48%, with the remainder of the bonds in the regions which have a high $sp^2/sp^3$-ratio being $sp^3$-bonds. Such a film is advantageous in that there is a high $sp^2/sp^3$-ratio in the $sp^2$-rich regions so as to ensure strong variation between those regions and the $sp^3$-rich regions, which enhances the advantageous properties of the DLC layer which were discussed above. In this respect, the term "fraction of the bonds" means the percentage of the bonds which are $sp^2$-bonds, compared with the total number of bonds. This quantity can for instance be measured in accordance with the EELS method described in the above-mentioned paper by A. J. Papworth et al., Phys. Rev. B, 62(2000) 12628-12631.

It is according to the invention, that the fraction of the bonds between carbon atoms which are $sp^2$-bonds in those regions of the carbon film which have a low $sp^2/sp^3$-ratio are within the range of from 20% to 35%, preferably within the range of from 29% to 33%, with the remainder of the bonds in the regions which have a low $sp^2/sp^3$-ratio being $sp^3$-bonds. Again, having such a range of the $sp^2$-bonds serves to ensure that there is a strong variation between $sp^2$-rich regions and $sp^3$-rich regions, because it implies a high $sp^3$-fraction That is, having such a range ensures a strong variation in the mechanical properties of the bonds and lead to a carbon film having a distinctly layered structure, in particular when combined with the features of claim 5.

It is also disclosed to vary the fraction of the bonds between carbon atoms which are $sp^2$-bonds by 10 to 20 percentage points, preferably 14 to 16 percentage points. This variation, which defines the variations

between $sp^2$-rich regions and $sp^3$-rich regions, also ensures that there is a strong and discernable variation between the different regions inside a DLC film, which leads to the advantages discussed above.

According to an aspect of the disclosure, a plasma enhanced physical vapor deposition (PVD)-method is used for coating a carbon film. Physical vapor deposition refers to a method of coating a layer onto a substrate where the coating material is turned into a vapor and is then deposited on the substrate without changing its chemical composition. The use of plasma enhanced physical vapor deposition means that a plasma is created to aid the deposition process. That is, one additionally uses a plasma so as to improve the physical vapor deposition.

According to the disclosure, a localized plasma is created inside a coating chamber. A coating chamber is used in physical vapor deposition so as to contain the vapor used for creating the film. The plasma which is created is localized. That is, the plasma does not have a uniform distribution throughout the whole of the coating chamber. Rather, it is present to a higher degree in some locations and present to a lower degree in some other locations. It could also be the case that it is only present in some parts of the coating chamber whilst other parts of the coating chamber do not contain any plasma at all. The use of such a localized plasma is advantageous as will be evident below. If choosing to have no plasma at all in some parts of the coating chamber, a particularly strong variation between regions which contain a plasma and those regions which do not contain a plasma is achieved. This is particularly advantageous for creating a carbon film having a strong variation between $sp^2$-rich regions and $sp^3$-rich regions, as will be evident further below.

The plasma is arranged such that a localized increase of the temperature of the substrate-surface is caused at the position where the substrate is exposed to the plasma. This is because the plasma increases the temperature of the substrate at the position where the substrate is exposed to it. As will be discussed below, this leads to a decrease in the fraction of the bonds between the newly deposited carbon atoms which are $sp^3$-bonds at said position due to the local rise in the coating surface temperature. Since some parts of the substrate are exposed to the localized plasma to a higher degree than other parts of the substrate, this rise in temperature only affects those parts of the substrate which are exposed to the plasma. That is, other parts of the substrate which are not exposed to the plasma or which are exposed to the plasma to a lower degree have a comparatively higher $sp^3$-fraction in the bonds between newly deposited carbon atoms.

According to the aspect, the substrate is kept at a temperature within a range of from 100°C to 180°C, preferably 140°C to 160°C. By keeping the substrate within that temperature range, the overall substrate temperature is such that for an increase in the temperature of the outer layers of the film due to the exposure to the plasma, a significant decrease in the $sp^2$-fraction occurs. That is, by having the temperature of the substrate maintained within the given temperature range, a discernable variation in the $sp^2$/$sp^3$-fraction can be obtained. Keeping the substrate temperature in a range of 140° to 160°C is particularly advantageous in that respect. By keeping the substrate within that temperature range, it is not excluded that there can be local variations of the temperature of the substrate due to the effect of the plasma. It is the average temperature of the substrate which is maintained within this range.

According to the aspect, there is a relative movement between the substrate and the localized plasma so that the degree to which different parts of the substrate are exposed to the localized plasma varies over time in an oscillating manner. By this relative movement, it is ensured that there is a change in the temperature of at least parts of the substrate to be coated. By this change in temperature, one obtains a variation in the $sp^2$/$sp^3$-ratio. Thus, in this way, one obtains a structure having an alternating sequence of $sp^2$-rich and $sp^3$-rich regions. By causing this relative movement in an oscillating manner, one obtains in particular an oscillating sequence of $sp^2$-rich and $sp^3$-rich regions, thereby leading to a structure having several layers of $sp^2$-rich and $sp^3$-rich regions arranged on top of each other.

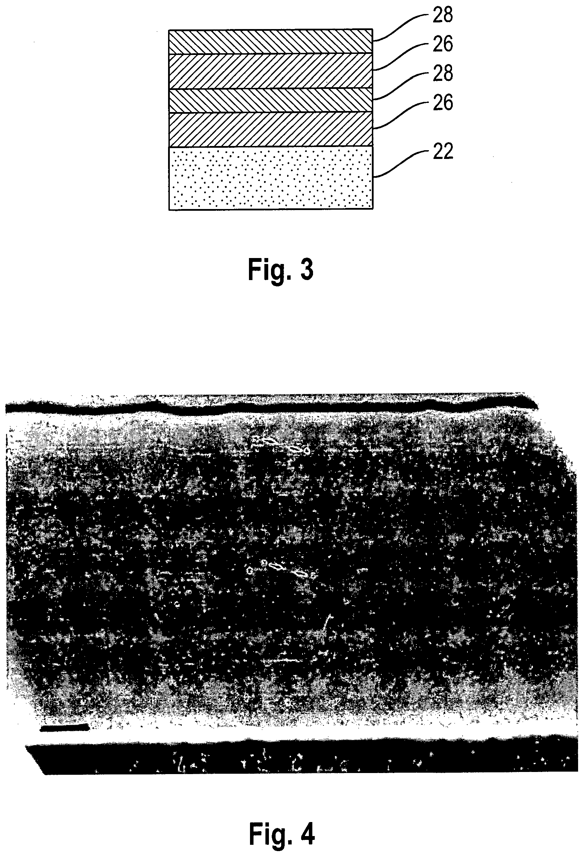

As mentioned above, an increase in the temperature at which new carbon atoms are deposited goes along with a decrease of the $sp^3$-fraction. This effect can, for example, be derived from the paper by B. Schultrich et al. cited above, which shows the behavior of the Young's modulus as a function of the substrate temperature during deposition (cf. Fig. 3). Since the hardness scales as 0.08-0.1 times the Young's modulus, and since it is known that the hardness and the $sp^3$/$sp^2$-ratio correlate linearly (S. Xu et al., "Mechanical properties and Raman spectra of tetrahedral amorphous carbon films with high sp3 fraction deposited using a filtered cathodic arc", Philosophical Magazine B, 1997, Vol. 76, No. 3, 351-361), it can thus be inferred that an increased temperature goes along with a reduced $sp^3$-fraction. In the inventive method, this effect is relied on to obtain a layered structure of a film having an alternating sequence of $sp^3$-rich layers and $sp^2$-rich layers. This is because, by only heating up parts of the substrate in the plasma whilst moving the substrate relative to the plasma, there is a time variation in the deposition conditions of the carbon atoms. Hence, a film is obtained which varies between $sp^2$-rich regions and $sp^3$-rich regions.

It has also been found that the reduction in the $sp^3$-fraction with increasing temperatures is particularly prominent for temperatures above about 100°C, since the hardness tends to fall off starting from a substrate temperature of about 100°C and is reduced by about half when the temperature increases by about 80°C. Maintaining the substrate temperature within the claimed range thus serves to ensure that the substrate temperature is within that temperature range where the effect mentioned above is particularly prominent.

In this respect, we also note that the substrate could consist of several disjoint substrates, that is substrates which are not physically connected to each other. They could, for example, be arranged on a turntable which moves them between regions of the coating chamber where they are exposed to the plasma to a higher degree and regions of the chamber where they are exposed to the plasma to a lower degree.

By the term "exposure" of the substrate or parts of the substrate to the plasma, it is meant that the plasma can contact the surfaces of the substrate. That is, the term "exposure to the plasma" means that the plasma can cause a temperature increase of the substrate.

Using the described method, a carbon film such as described previously can be obtained in an efficient manner. In particular, one can use the well-characterized and widespread method of physical vapor deposition, thereby reducing the costs required for producing such a film. Further, because physical vapor deposition is a well-established method, the films thus produced has a high quality and can be produced with a high reliability, which is advantageous in that the films which are thus produced have highly predictable properties, which is important for selling products coated by them. Also, compared with the prior art methods, one can keep the parameters used for producing them (such as the biasing voltage of the substrate, the overall substrate temperature, and the pressure inside the coating chamber) constant, thus avoiding a complicated control of the device used for producing them.

In a preferred variant of the described method, the fraction of the bonds between the newly deposited carbon atoms which are $sp^3$-bonds is reduced by at least 5 percentage points, preferably at least 10 percentage points, and more preferably at least 12 percentage points due to the localized increase of the temperature caused by the plasma. That is, the heating up of the outer surface of the carbon film due to the localized plasma is so significant that there is such a noticeable drop in the fraction of the $sp^3$-bonds. Doing so is advantageous because the carbon film thus obtained has good mechanical properties.

It is also preferred if the film is deposited at a rate of growth of greater than 1 nm/s or even greater than 3 nm/s. Having such a rate of growth is advantageous in that a carbon film is produced comparatively quickly. Since one can thereby have a high speed of coating the substrates, the costs for coating them is reduced, thereby making them more marketable.

It is also preferred that the plasma is produced by an arc discharge between an anode and a carbon cathode. Using such a method of producing a plasma is a well-established way of creating such a plasma. By using a carbon cathode, one automatically produces the carbon vapor to be deposited. According to an embodiment, the arc discharge is created by the superposition of a constant DC voltage with a sequence of pulses, which preferably have at least a high initial voltage rise rate. In accordance with the present invention, a high initial voltage rise rate is a rate of more than 1 v/$\mu$s, preferably more than 5 v/$\mu$s, more preferably more than 10 V/ps, still more preferably more than 20 V/ps. The upper limit of the initial voltage rise rate is not specifically limited and can be up to infinite (steplike or rectangular pulse). Herein, the term "initial voltage rise rate" defines the voltage rise (ramp-up) rate at the beginning of the pulse, which preferably means herein at least the first 10%, more preferably at least the first 20%, still more preferably at least the first 50%, in terms of the overall pulse width. The further course (shape) of the pulse after the initial voltage rise (ramp-up) is not specifically limited in kind and can be a constant voltage, a further lower voltage rise or a slight voltage decrease. The pulse width of the pulses superimposed on the constant DC voltage and having at least a high initial voltage rise rate is preferably in the range of 1 to 100 $\mu$s, more preferably in the range of 2 to 50 $\mu$s, still more preferably in the range of 3 to 20 ps. The pulse height of the pulses superimposed on the constant DC voltage and having at least a high initial voltage rise rate is preferably in the range of 30 to 120 V, more preferably in the range of 40 to 100 V, still more preferably in the range of 50 to 100 V. Using such a pulse shape for creating a plasma has proven to be particularly advantageous for producing a high intensity plasma, that is, a (localized) plasma which leads to a rapid increase of the temperature of the substrate to be coated. Given the dependence of the $sp^2/sp^3$-ratio on the temperature at which the carbon film is produced, this is advantageous in producing a carbon film having the distinct sequence of $sp^2$-rich and $sp^3$-rich regions discussed above.

According to the preferred method, one typically has an arc discharge current within the range of 50 A to 1000 A. The background partial pressure of reactive gases (that is, gases which may react with the film to be formed) inside the chamber is typically around $5 \times 10^{-5}$ mbar. In addition to that, in order to aid in the arc ignition, one can have a quantity of argon inside the chamber up to a partial pressure of $5 \times 10^{-4}$ mbar. Further, to improve the coating process, the substrates to be coated are typically previously cleaned by argon etching, that is, by bombardment with argon ions, which occurs prior to depositing the carbon film. Further, in order to improve the adhesion of the carbon layer, once can provide an initial adhesion layer made of metallic chromium or metallic titanium. However, doing so is not necessary.

The deposition parameters can stay constant throughout the whole deposition process, that is, one does not change the pressure and the gas atmosphere. Further, the bias voltage of the substrate is preferably within the range from 30 to 100 V, more preferably in in the range from 50 to 100 V.

The plasma deposition conditions are selected so that a highly intense plasma (high intensity plasma) is present as the (localized) plasma. The effect of the highly intense plasma is that the outer surface of the film is bombarded with ions and thus heats up locally during the time in which the film passes in front of the active cathode. As explained above, the high intensity can be achieved by adding a voltage having a high rise onto a DC arc discharge voltage. The arc current sweeps up temporarily, leading to a rapid increase of the plasma density. Accordingly, the ion bombardment of the product surface also increases rapidly.

This ion bombardment of the surface is assisted by a self-biasing effect. During the start of the pulse, a cloud of electrons is created, which electrons travel much faster than the carbon ions. The self-biased voltage depends on the plasma voltage. With a voltage rise rate of more than 10 v/$\mu$s, plasma voltages of up to 100 V were monitored.

The power which is dissipated in the film due to the ion bombardment is enhanced by the self-biasing effect. The modulation of the power becomes particularly visible when the power dissipated into the film when passing the cathode is above 800 W/m$^2$, especially when it is above 1,000 W/m$^2$.

The effect of this is that the film starts to grow with the same temperature or at the substrate, which is kept stable. When in front of the cathode, the outer surface of the film heats up. The growing film starts with the deposition on a film with the same temperature as the substrate. However, during the time that the substrate passes the cathode, the temperature at the outer nanometers of the film goes up, directly influencing the $sp^2/sp^3$-ratio of the growing film, which results in a lower Young's modulus, hardness and $sp^3$-fraction.

One point in this respect is that the heating rate is high so that during the time that the substrate passes the cathode (or, to be more precise, the part of the substrate to be coated), the film surface is heated so much that the $sp^3$-fraction is reduced whilst the $sp^2$-fraction is increased. If the heating rate is too slow so as to merely result in a heating of the film throughout, one will not achieve a nano-modulation of the $sp^2/sp^3$-ratio, as was discussed above.

It is preferred if at least some or all of the pulses have at least an initial voltage rise rate of more than 1 V/ps, more preferably of more than 5 V/ps and still more preferably of more than 10 V/ps. Having such a high initial voltage rise rate (that is, a time derivative of the voltage which is applied between the anode and the cathode) is advantageous in creating a high intensity plasma, which leads to the advantages mentioned above. It is also preferred that the pulses are applied at a frequency within a range of from 10kHz to 100kHz, again to create and maintain a high intensity plasma. Having a lower frequency would lead to a too significant fall off of the plasma intensity. Having a higher pulse rate would overly increase the plasma intensity.

It is also preferred to have a plasma current density of more than 0.1 A/cm$^2$ at the substrate. This feature is advantageous in that it also leads to a high intensity plasma.

Brief Description of the Drawings

FIG. 1 is a schematic drawing of an apparatus to be used in a method to produce a carbon film according to the invention.

FIG. 2 is a schematic representation of the voltage applied across an anode and a cathode of a plasma enhanced PVD apparatus.

FIG. 3 is a schematic representation of an inventive carbon film.

FIGs. 4 and 5 show electron micrographs of an inventive carbon film.

FIG. 6 shows a film produced using a method not falling under the invention.

FIGs. 7 and 8 show comparative wear tests.

Detailed Description of the Drawings

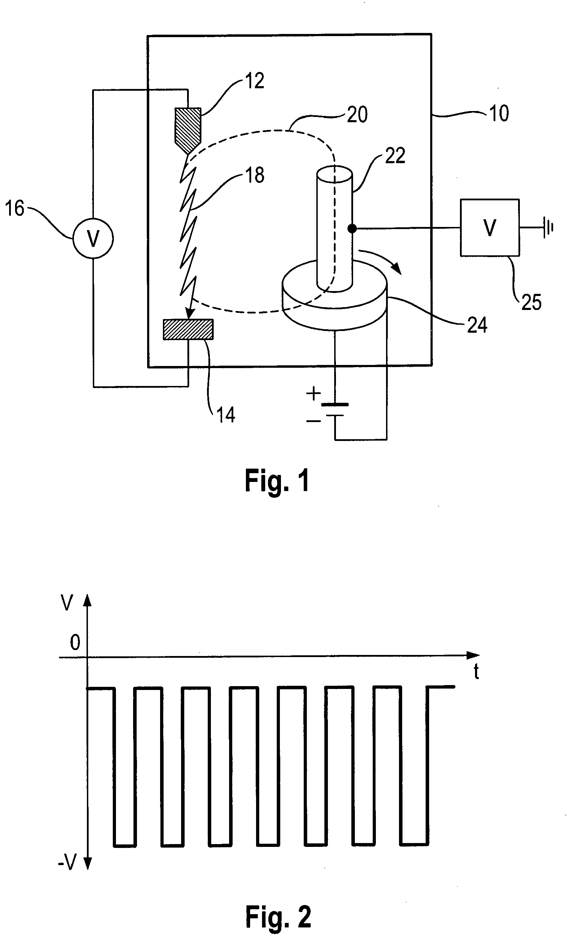

FIG. 1 shows, schematically, an apparatus which can be used for performing a method to produce an inventive substrate.

In a coating chamber 10, a discharge 18 is created between an anode 12 and a cathode 14 which is essentially made of pure carbon. The voltage which is applied by voltage supply 16 has the overall shape which is shown in FIG. 2, namely a superposition of a sequence of rectangular pulses on a constant DC voltage.

Due to the discharge 18, a plasma 20 is created, whose spatial extent inside the coating chamber 10 is indicated by a dashed line in FIG. 1.

Furthermore, inside the coating chamber 10, there is provided a metallic substrate 22 which is exposed to the plasma 20 at one of its sides and to which a biasing voltage is applied by a voltage source 25. Due to the carbon vapor present inside the coating chamber 10 which is created due to the interaction of the discharge 19 with the carbon cathode 14, carbon atoms are deposited on the substrate 22. Substrate 22 is kept at a temperature of 150°C. Due to the localized increase of the temperature in that region of the substrate 22 which is exposed to the plasma 20, there is a localized increase in the temperature of the substrate 22. This localized increase of the temperature means that those carbon atoms which are deposited in that region have a lower fraction of $sp^3$-bonds formed between them. In contrast, those carbon atoms which are deposited in regions of the substrate 22 which are not exposed to the plasma 20 have a lower temperature and therefore have a higher fraction of bonds which are $sp^3$-bonds.

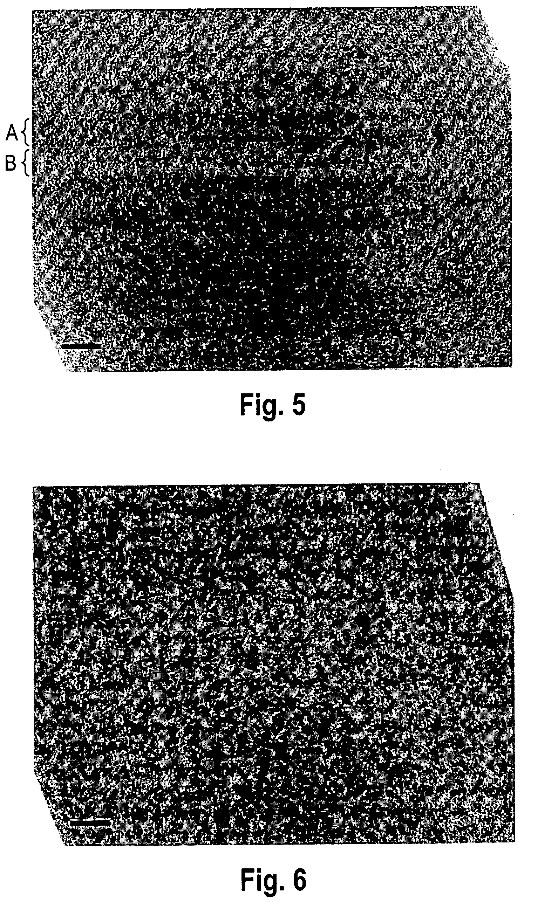

The system used to obtain the carbon films illustrated in Figs. 4 and 5 was equipped with 6 ARC cathodes, of which in between 1 and 3 were used in parallel. The number of the cathodes which are used however is not critical and can be adapted according to the size of the vacuum chamber. The cathodes were supplied with a DC ARC current superimposed with a sequence of peak pulses, i.e. voltage pulses having at least a high initial voltage rise rate. The pulses were created by a charge voltage which is applied to a capacitor, thereby charging it, and subsequently directly connecting it to the cathode. The level of the charge voltage determines, to a large extent, the rise rate of the voltage at the cathode. In the present embodiment, as short a wiring as possible was used. This is because longer wires result in a lower voltage rise rate at the cathode. The charge voltage is not further limited and can be within the range of from 200 V to 1000 V. It is preferably in the range of 200 V and 500 V. The examples shown in Figures 4 and 5 have been obtained when using a charge voltage of 250 V.

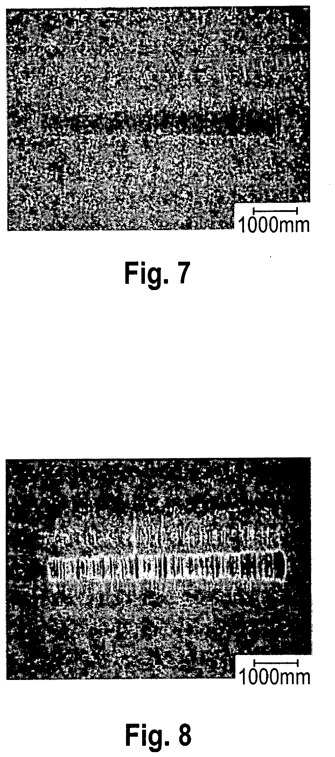

Whilst the DC arc current can for instance be between 40 and 200 A, in the present embodiment it was 45 A. The peak arc current can typically be between 100 A and 1500 A, and it is preferably between 200 and 500 A. The examples in Figs. 4 and 7 have been produced with a peak current of 400 to 410 A on top of the DC arc current mentioned above. The peak arc current was measured at the cathode. In total, a peak arc current as a sum of the two contributions of 450 A was obtained. In general, the peak current can be controlled by setting the pulse width and the charge voltage for the capacitor.

The peak Arc voltage measured between cathode and anode (chamber wall) with the above pulse was in the present embodiment 70 to 75 Volts. This includes the base DC arc voltage mentioned above.

When preparing the samples shown in Figs. 4 and 5, a bias voltage between the samples and ground was a 60V DC voltage. More generally, it can for instance be within the range of from 30 to 100 V.

Whilst the samples in Figs. 4 and 5 have been obtained with a pulse width of 5 μs, the best results have been obtained more generally with pulse widths between 3 and 20 ps.

The pulse-off time (which helps avoid overheating of the film) was 80μs for the samples shown in Figs. 4 and 5.

The substrate 22 is rotated inside the coating chamber 10 by means of a motor 24. In such a way, different parts of the substrate 22 are exposed to the plasma 20, thus creating a spatial variation of the $sp^2/sp^3$-ratio of the carbon film deposited on the substrate. Once several such layers of carbon have been deposited, one obtains a carbon film having an alternating sequence of $sp^2$-rich and $sp^3$-rich layers arranged on top of each other.

The rotation speed is chosen such that the product 22 passes with its region which is exposed to the plasma 20 through the plasma 20 within 3s.

Schematically, a thin film produced using the claimed method is shown in FIG. 3. In this figure, a substrate 22 is shown which has arranged thereon a sequence of $sp^2$-rich films 26 which are sandwiched by two $sp^3$-rich films 28. The thickness of those films 26, 28 is on a nanometer scale.

FIG. 4 shows a transmission electron microscope (TEM) image of a non-hydrogenated tetrahedral carbon film in a cross section. The black bar indicated towards the bottom of that drawing corresponds to a length of 100 nm. $Sp^2$-rich and $sp^3$-rich regions of the carbon film are visible as bands.

A more detailed view of those films can be seen from the electron micrograph in FIG. 5. In that electron micrograph, the black bar corresponds to 10 nm. As can be seen as brighter and darker bands marked by A and B, there is a variation in the $sp^2/sp^3$-ratio. In contrast, a TEM image produced of a tetrahedral carbon coating with normal deposition conditions which is shown in FIG. 6 (where the bar also corresponds to a length of 10nm) does not show corresponding variations.

A comparison of the wear and tear tests of inventive films, when compared with films not having such an oscillation in the $sp^2/sp^3$-ratio, is shown in FIGs. 7 and 8, where FIG. 7 shows the result on an inventive multilayer structure and where FIG. 8 shows the result on a prior art structure. Those tests, which were rapid wear tests, were performed by pushing a sample having a DLC coating with a force of 294 N against a circular disc spinning at 200 rpm. As lubricant the GF-5 oil according to the International Standardization and Approval Committee (ILSAC) was used (more specifically, Toyota castle SN 0W-20, API indication SN, ILSAC GF-5, SAW 0W-20).

The lubricant having a temperature of 80°C was added at the interface. The spinning direction of the disc was maintained for 3 seconds. The disc was then stopped for 2 seconds and was driven in the reverse direction at 200 rpm, again for a time period of 3 seconds. After stopping the disc for 2 seconds, this cycle was repeated. As can be seen visually by comparing FIGs. 7 and 8, Fig. 8 shows significantly more wear and tear. This was confirmed by measuring the wear depth which, in the case of FIG. 7 was $0.059\mu m$ whilst being $0.118\mu m$ in the case of FIG. 8. Thus, as can be seen from those two figures, the inventive film has superior wear properties, compared with prior art films.

The present inventors have found out that in a method to produce the coating of the invention, a combination of a substrate temperature within the range of from 140°C-160°C, a film growth rate of more than 1 nm/s, a voltage rise rate of more than 10 V/ps, a pulse duration between 3 and 20 $\mu s$, a pulse-off time of 80 $\mu s$, a DC arc current of between 40 and 200 A, a peak arc current between 100 A and 1500 A and a biasing voltage of the substrate between 30 and 100 V yields preferred carbon films, especially ta-C films.

## Claims

1. Substrate having a carbon film (26, 28) as a coating,

   the carbon film having an oscillating variation of the $sp^2/sp^3$-ratio in the thickness direction of the carbon film so that neighboring regions (26) having a high $sp^2/sp^3$-ratio are spaced apart from each other by at least 0.2 nm and sandwich a region having a lower $sp^2/sp^3$-ratio (28), wherein the distance between neighboring regions (26) having a high $sp^2/sp^3$-ratio is less than 50 nm, **characterized in that** the fraction of the bonds between carbon atoms being $sp^2$-bonds in regions (26) which have a high $sp^2/sp^3$-ratio is within the range of from 40%-50%, with the remainder of the bonds in the regions (26) which have a high $sp^2/sp^3$-ratio being $sp^3$-bonds, wherein the fraction of the bonds between carbon atoms being $sp^2$-bonds in those regions of the carbon film which have a lower $sp^2/sp^3$-ratio is within the range of from 20%-35%, with the remainder of the bonds in the regions which have a lower $sp^2/sp^3$-ratio being $sp^3$-bonds.

2. The substrate according to claim 1, wherein the neighboring regions (26) having a high $sp^2/sp^3$-ratio are spaced apart from each other by at least 3 nm, preferably by at least 5 nm.

3. The substrate according to claim 1 or 2, wherein the distance between neighboring regions (26) having a high $sp^2/sp^3$-ratio is less than 25 nm, preferably less than 15 nm.

4. The substrate according to any one of claims 1 to 3, which has a hydrogen content of less than 1 mole percent.

5. The substrate according to any one of claims 1 to 4, wherein the fraction of the bonds between carbon atoms being $sp^2$-bonds in regions (26) which have a high $sp^2/sp^3$-ratio is within the range of from 41%-48%, with the remainder of the bonds in the regions (26) which have a high $sp^2/sp^3$-ratio being $sp^3$-bonds.

6. The substrate according to any one of claims 1 to 5, wherein the fraction of the bonds between carbon atoms being $sp^2$-bonds in those regions of the carbon film which have a lower $sp^2/sp^3$-ratio is within the range of from 29%-33%, with the remainder of the bonds in the regions which have a lower $sp^2/sp^3$-ratio being $sp^3$-bonds.

7. The substrate according to any one of the preceding claims,

wherein the carbon film is a tetrahedral diamond like carbon film.

**Patentansprüche**

1. Substrat, aufweisend einen Kohlenstofffilm (26, 28) als Beschichtung, wobei der Kohlenstofffilm eine oszillierende Variation des $sp^2/sp^3$-Verhältnisses in der Dickenrichtung des Kohlenstofffilms aufweist, so dass benachbarte Bereiche (26), die ein hohes $sp^2/sp^3$-Verhältnis aufweisen, um mindestens 0,2 nm voneinander beabstandet sind und sandwichartig einen Bereich einschließen, der ein niedrigeres $sp^2/sp^3$-Verhältnis (28) aufweist,

   wobei der Abstand zwischen benachbarten Bereichen (26), die ein hohes $sp^2/sp^3$-Verhältnis aufweisen, weniger als 50 nm beträgt, **dadurch gekennzeichnet, dass** der Anteil der Bindungen zwischen Kohlenstoffatomen, die $sp^2$-Bindungen sind, in Bereichen (26), die ein hohes $sp^2/sp^3$-Verhältnis aufweisen, im Bereich von 40%-50% liegt, wobei der Rest der Bindungen in den Bereichen (26), die ein hohes $sp^2/sp^3$Verhältnis aufweisen, $sp^3$-Bindungen sind, wobei der Anteil der Bindungen zwischen Kohlenstoffatomen, die $sp^2$-Bindungen sind, in denjenigen Bereichen des Kohlenstofffilms, die ein niedrigeres $sp^2/sp^3$-Verhältnis aufweisen, im Bereich von 20 % bis 35 % liegt, während der Rest der Bindungen in den Bereichen, die ein niedrigeres $sp^2/sp^3$-Verhältnis aufweisen, $sp^3$-Bindungen sind.

2. Substrat nach Anspruch 1, wobei die benachbarten Bereiche (26), die ein hohes $sp^2/sp^3$-Verhältnis aufweisen, um mindestens 3 nm, bevorzugt um mindestens 5 nm, voneinander beabstandet sind.

3. Substrat nach Anspruch 1 oder 2, wobei der Abstand zwischen benachbarten Bereichen (26), die ein hohes $sp^2/sp^3$-Verhältnis aufweisen, weniger als 25 nm, bevorzugt weniger als 15 nm beträgt.

4. Substrat nach einem der Ansprüche 1 bis 3, das einen Wasserstoffgehalt von weniger als 1 Molprozent aufweist.

5. Substrat nach einem der Ansprüche 1 bis 4, wobei der Anteil der Bindungen zwischen Kohlenstoffatomen, die $sp^2$-Bindungen sind, in Bereichen (26), die ein hohes $sp^2/sp^3$-Verhältnis aufweisen, im Bereich von 41 % bis 48 % liegt, wobei der Rest der Bindungen in den Bereichen (26), die ein hohes $sp^2/sp^3$-Verhältnis aufweisen, $sp^3$-Bindungen sind.

6. Substrat nach einem der Ansprüche 1 bis 5, wobei der Anteil der Bindungen zwischen Kohlenstoffatomen, die $sp^2$-Bindungen sind, in denjenigen Bereichen des Kohlenstofffilms, die ein niedrigeres $sp^2/sp^3$-Verhältnis aufweisen, im Bereich von 29 % bis 33 % liegt, während der Rest der Bindungen in den Bereichen, die ein niedrigeres $sp^2/sp^3$-Verhältnis aufweisen, $sp^3$-Bindungen sind.

7. Substrat nach einem der vorstehenden Ansprüche, wobei der Kohlenstofffilm ein tetraedrischer diamantähnlicher Kohlenstofffilm ist.

**Revendications**

1. Substrat présentant un film de carbone (26, 28) en tant que revêtement, le film de carbone présentant une variation oscillante du rapport $sp^2/sp^3$ dans la direction d'épaisseur du film de carbone de sorte que les régions voisines (26) présentant un rapport $sp^2/sp^3$ élevé sont mutuellement espacées d'au moins 0,2 nm et enserrent une région présentant un rapport $sp^2/sp^3$ inférieur (28),

   dans lequel la distance entre des régions voisines (26) présentant un rapport $sp^2/sp^3$ élevé est inférieure à 50 nm, **caractérisé en ce que** la fraction des liaisons entre des atomes de carbone étant des liaisons $sp^2$ dans des régions (26) qui présentent un rapport $sp^2/sp^3$ élevé se situe dans la plage de 40 % à 50 %, le reste des liaisons dans les régions (26) qui présentent un rapport $sp^2/sp^3$ élevé étant des liaisons $sp^3$, dans lequel la fraction des liaisons entre des atomes de carbone étant des liaisons $sp^2$ dans ces régions du film de carbone qui présentent un rapport $sp^2/sp^3$ inférieur est dans la plage de 20 % à 35 %, le reste des liaisons dans les régions qui présentent un rapport $sp^2/sp^3$ inférieur étant des liaisons $sp^3$.

2. Substrat selon la revendication 1, dans lequel les régions voisines (26) présentant un rapport $sp^2/sp^3$ élevé sont mutuellement espacées d'au moins 3 nm, de préférence d'au moins 5 nm.

3. Substrat selon la revendication 1 ou 2, dans lequel la distance entre des régions voisines (26) présentant un rapport $sp^2/sp^3$ élevé est inférieure à 25 nm, de préférence inférieure à 15 nm.

4. Substrat selon l'une quelconque des revendications 1 à 3, qui présente une teneur en hydrogène inférieure à 1 % en mole.

5. Substrat selon l'une quelconque des revendications 1 à 4,

dans lequel la fraction des liaisons entre des atomes de carbone étant des liaisons $sp^2$ dans des régions (26) qui présentent un rapport $sp^2/sp^3$ élevé se situe dans la plage de 41 % à 48 %, le reste des liaisons dans les régions (26) qui présentent un rapport $sp^2/sp^3$ élevé étant des liaisons $sp^3$.

6. Substrat selon l'une quelconque des revendications 1 à 5,
   dans lequel la fraction des liaisons entre des atomes de carbone étant des liaisons $sp^2$ dans ces régions du film de carbone qui présentent un rapport $sp^2/sp^3$ inférieur se situe dans la plage de 29 % à 33 %, le reste des liaisons dans les régions qui présentent un rapport $sp^2/sp^3$ inférieur étant des liaisons $sp^3$.

7. Substrat selon l'une quelconque des revendications précédentes,
   dans lequel le film de carbone est un film de carbone de type diamant tétraédrique.

**Fig. 1**

**Fig. 2**

**Fig. 3**

**Fig. 4**

A{
B{

**Fig. 5**

**Fig. 6**

**Fig. 7**

**Fig. 8**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2298954 A1
- EP 2561118 B1
- US 6066399 A
- JP 2005350763 A

**Non-patent literature cited in the description**

- **J. PATSCHEIDER et al.** Structure-performance relations in nanocomposite coatings. *Surface and Coatings Technology,* 2001, vol. 146-147, 201-208
- **P.EH. HOVSEPIAN.** Recent progress in large scale manufacturing of multilayer/superlattice hard coatings. *Technology,* 2000, vol. 133-134, 166-175
- **J. MUSIL.** Hard nanocomposite coatings: Thermal stability, oxidation resistance and toughness. *Surface & Coatings Technology,* 2012, vol. 207, 50-65
- **C. STRONDL et al.** Properties and characterization of multilayers of carbides and diamond-like carbon. *Surface and Coatings Technology,* 2001, vol. 142-144, 707-713
- **B. SCHULTRICH et al.** Deposition of superhard amorphous carbon films by pulsed vacuum arc deposition. *Surface and Coatings Technology,* 1998, vol. 98, 1097-1101
- **T. WITKE et al.** Comparison of filtered high-current pulsed arc deposition (Φ-HCA) with conventional vacuum arc methods. *Surface and Coatings Technology,* 2000, vol. 126, 81-88
- **P. PATSALAS et al.** Surface and interface morphology and structure of amorphous carbon thin and multilayer films. *Diamonds & Related Materials,* 2005, vol. 14, 1241-1254
- **MATHIOUDAKIS et al.** Nanomechanical properties of multilayered amorphous carbon structures. *Phys. Rev. B,* (65), 205203
- **FENGJI LI et al.** Multilayer DLC coatings via alternating bias during magnetron sputtering. *Thin Solid Films,* 2011, vol. 519, 4910-4916
- **S.D. BERGER et al.** *Phil. Mag. Lett.,* 1988, vol. 57, 285
- **A. J. PAPWORTH et al.** Electron-energy-loss spectroscopy characterization of the sp2 bonding fraction within carbon thin films. *Phys. Rev. B,* 2000, vol. 62, 12628-12631
- **A. J. PAPWORTH et al.** *Phys. Rev. B,* 2000, vol. 62, 12628-12631
- **S. XU et al.** Mechanical properties and Raman spectra of tetrahedral amorphous carbon films with high sp3 fraction deposited using a filtered cathodic arc. *Philosophical Magazine B,* 1997, vol. 76 (3), 351-361